# EUROPEAN PATENT APPLICATION

(11) **EP 4 757 575 A2**
(43) Date of publication of application: **10.06.2026**
(21) Application number: 25197328.5
(22) Date of filing: 21.08.2025
(51) Int. Cl.: H10W 90/20, H10W 74/10, H10W 90/00

(54) **SEMICONDUCTOR DEVICE WITH TWO DIFFERENT TYPES OF MEMORY CHIPS AND A BRIDGE CHIP**

(30) Priority: 09.12.2024 JP 2024214527
(71) Applicant: Kioxia Corporation, Tokyo 108-0023 (JP)
(72) Inventor: Otsuka, Yasuo, Tokyo, 108-0023 (JP)
(74) Representative: Marks & Clerk LLP

(57) **Abstract**

In one embodiment, a semiconductor device includes a substrate, and a chip stack including a plurality of chips stacked on the substrate. The plurality of chips include a first memory chip, a second memory chip, a type of the second memory chip being different from a type of the first memory chip, and a first bridge chip that electrically connects the first memory chip and the second memory chip.

## Description

### FIELD

Embodiments described herein relate to a semiconductor device.

### BACKGROUND

When a plurality of types of memory chips are mounted on a package substrate, it is a problem what kind of mode is to be employed to mount these memory chips.

### BRIEF DESCRIPTION OF THE DRAWINGS

FIG. 1 is a block diagram illustrating a configuration of an information processing device of a first embodiment;
FIG. 2 is a sectional view illustrating a structure of a semiconductor device of the first embodiment;
FIGS. 3A and 3B are sectional views illustrating two examples of the structure of the semiconductor device of the first embodiment;
FIGS. 4A to 10 are sectional views illustrating a first example of a method of manufacturing the semiconductor device of the first embodiment;
FIGS. 11A to 18 are sectional views illustrating a second example of the method of manufacturing the semiconductor device of the first embodiment;
FIG. 19 is a block diagram illustrating a configuration of an information processing device of a second embodiment;
FIG. 20 is a sectional view illustrating a structure of a semiconductor device of the second embodiment;
FIG. 21 is a block diagram illustrating a configuration of an information processing device of a third embodiment; and
FIG. 22 is a sectional view illustrating a structure of a semiconductor device of the third embodiment.

### DETAILED DESCRIPTION

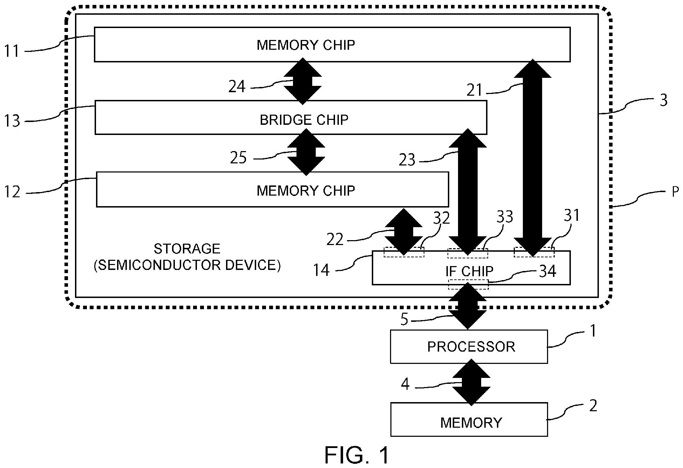

Embodiments will now be explained with reference to the accompanying drawings. In FIGS. 1 to 22, the same configurations are denoted by the same reference symbols, and redundant description is omitted.

In one embodiment, a semiconductor device includes a substrate, and a chip stack including a plurality of chips stacked on the substrate. The plurality of chips include a first memory chip, a second memory chip, a type of the second memory chip being different from a type of the first memory chip, and a first bridge chip that electrically connects the first memory chip and the second memory chip.

### (First Embodiment)

FIG. 1 is a block diagram illustrating a configuration of an information processing device of a first embodiment.

The information processing device of the present embodiment includes a processor 1, a memory 2, a storage 3, a bus 4, and a bus 5. The information processing device of the present embodiment is, for example, a computer such as a smart phone.

The processor 1 executes various types of information processing. The processor 1 is, for example, a CPU (Central Processing Unit). The memory 2 temporarily stores various types of data. The memory 2 is, for example, a RAM (Random Access Memory). The storage 3 stores various types of data. Details of the storage 3 are described later.

The bus 4 is used for communication between the processor 1 and the memory 2. The bus 5 is used for communication between the processor 1 and the storage 3. The bus 4 and the bus 5 may be the same bus, or may be different buses.

The storage 3 includes a memory chip 11, a memory chip 12, a bridge chip 13, and an IF (interface) chip 14. The memory chip 11 is an example of a first memory chip. The memory chip 12 is an example of a second memory chip. The bridge chip 13 is an example of a first bridge chip.

The memory chip 11 and the memory chip 12 have types different from each other. For example, the memory chip 11 and the memory chip 12 are different in at least one of a data retaining method, a memory capacity, and an access speed. The memory chip 11 is, for example, a non-volatile memory such as a flash memory. The memory chip 12 is, for example, a non-volatile memory such as a storage-class memory. In this case, both of the memory chips 11 and 12 retain data in a non-volatile manner, and hence the data retaining methods of the memory chips 11 and 12 are the same. Further, the memory chip 11 has a large capacity and the memory chip 12 has a small capacity, and hence the memory capacities of the memory chips 11 and 12 are different. Further, the access speed of the memory chip 11 is low and the access speed of the memory chip 12 is high, and hence the access speeds of the memory chips 11 and 12 are different. Each of the memory chips 11 and 12 includes, for example, a memory cell array including a plurality of memory cells, and a circuit (for example, a CMOS circuit) including a plurality of transistors that control the plurality of memory cells.

The bridge chip 13 is disposed between the memory chip 11 and the memory chip 12 to electrically connect the memory chip 11 and the memory chip 12. The bridge chip 13 has a function of transferring data between memory chips that have types different from each other. In the present embodiment, the type of memory chip 12 is different from the type of the memory chip 11, and hence the bridge chip 13 is disposed between the memory chip 11 and the memory chip 12. The bridge chip 13 transfers data from one of the memory chips 11 and 12 to the other of the memory chips 11 and 12.

The IF chip 14 is electrically connected to the memory chip 11, the memory chip 12, the bridge chip 13, and the bus 5 (processor 1). The IF chip 14 functions as an interface between each of the memory chip 11, the memory chip 12, and the bridge chip 13 and the bus 5 (the processor 1). For example, the IF chip 14 receives a signal from the processor 1, and accesses the memory chip 11, the memory chip 12, or the bridge chip 13 based on this signal. As an example, the IF chip 14 transmits a command to the bridge chip 13, and the bridge chip 13 transfers data from the memory chip 12 to the memory chip 11 based on this command. This makes it possible to transfer this data from the memory chip 12 to the memory chip 11 without temporarily storing this data into the memory 2. An example of such a command is a write command for use in writing data to the memory chip 11.

The storage 3 of the present embodiment is used when, for example, information processing for an AI (Artificial Intelligence) is executed by the processor 1. The present embodiment makes it possible to execute information processing at high speed by transferring data between the memory chips 11 and 12 without going through the memory 2. Examples of such information processing include information processing regarding inference of the AI.

The storage 3 of the present embodiment is a semiconductor device having a form of a semiconductor package P. The memory chip 11, the memory chip 12, the bridge chip 13, and the IF chip 14 of the present embodiment are mounted on a package substrate to be described later, and form a part of the semiconductor package P.

The storage 3 further includes a through electrode 21 that is an example of a first electrode, a through electrode 22 that is an example of a second electrode, a through electrode 23 that is an example of a third electrode, a through electrode 24 that is an example of a fourth electrode, and a through electrode 25 that is an example of a fifth electrode. Further, the IF chip 14 includes a metal pad 31 that is an example of a first pad, a metal pad 32 that is an example of a second pad, a metal pad 33 that is an example of a third pad, and a metal pad 34 that is an example of a fourth pad. The through electrodes 21 to 25 and the metal pads 31 to 34 also form a part of the semiconductor package P.

The through electrode 21 is provided to electrically connect the memory chip 11 and the IF chip 14. The through electrode 22 is provided to electrically connect the memory chip 12 and the IF chip 14. The through electrode 23 is provided to electrically connect the bridge chip 13 and the IF chip 14. The IF chip 14 can use the through electrode 21 to access the memory chip 11, use the through electrode 22 to access the memory chip 12, and use the through electrode 23 to access the bridge chip 13.

The through electrode 24 is provided to electrically connect the memory chip 11 and the bridge chip 13. The through electrode 25 is provided to electrically connect the memory chip 12 and the bridge chip 13. The bridge chip 13 can use the through electrodes 24 and 25 to transfer data from one of the memory chips 11 and 12 to the other of the memory chips 11 and 12.

The metal pad 31 is electrically connected to the through electrode 21. The metal pad 32 is electrically connected to the through electrode 22. The metal pad 33 is electrically connected to the through electrode 23. The IF chip 14 can use the metal pad 31 to access the memory chip 11, use the metal pad 32 to access the memory chip 12, and use the metal pad 33 to access the bridge chip 13.

The metal pad 34 is electrically connected to the bus 5. The IF chip 14 can use the metal pad 34 to perform communication with the processor 1 and the memory 2.

The present embodiment makes it possible to accommodate and use, with the bridge chip 13 and the IF chip 14 being adopted, the memory chips 11 and 12 having types different from each other in the same semiconductor package P. This makes it possible to reduce a total area of the storage 3 on a mother board of the information processing device of the present embodiment, and makes it possible to downsize the information processing device of the present embodiment. Thus, the storage 3 of the present embodiment is suitable for, for example, mobile equipment such as a smart phone.

Hereinafter, further details of the storage 3 of the present embodiment are described. In the following description, the storage 3 of the present embodiment is also referred to as "semiconductor device 3".

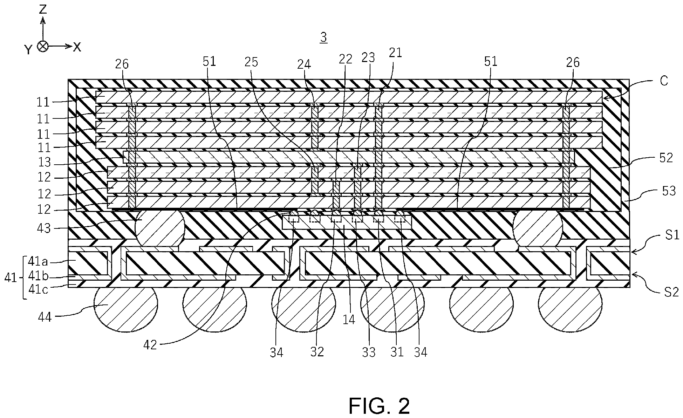

FIG. 2 is a sectional view illustrating the structure of the semiconductor device 3 of the first embodiment.

The semiconductor device 3 includes, as illustrated in FIG. 2, a plurality of memory chips 11 and a plurality of memory chips 12. The memory chips 11 illustrated in FIG. 2 correspond to the memory chip 11 illustrated in FIG. 1, and have structures and functions similar to those of the memory chip 11 illustrated in FIG. 1. Similarly, the memory chips 12 illustrated in FIG. 2 correspond to the memory chip 12 illustrated in FIG. 1, and have structures and functions similar to those of the memory chip 12 illustrated in FIG. 1.

The semiconductor device 3 further includes, as described above, the bridge chip 13, the IF chip 14, the through electrodes 21 to 25, and the metal pads 31 to 34. The semiconductor device 3 further includes a plurality of through electrodes 26, a substrate 41, a plurality of bumps 42, a plurality of bumps 43, a plurality of external connecting terminals 44, a plurality of wirings 51, a resin layer 52, and a resin layer 53. The through electrodes 26 are an example of a sixth electrode.

The substrate 41 is, for example, a package substrate (a wiring board). FIG. 2 illustrates an X direction and a Y direction that are parallel with an upper face and a lower face of the substrate 41 and are perpendicular to each other, and a Z direction perpendicular to the upper face and the lower face of the substrate 41. The X direction, the Y direction, and the Z direction intersect with each other.

The substrate 41 includes an insulating substrate 41a, a wiring layer 41b, and a resin layer 41c. FIG. 2 illustrates an upper face S1 and a lower face S2 of the insulating substrate 41a. The wiring layer 41b and the resin layer 41c are formed in order on the upper face S1 and the lower face S2 of the insulating substrate 41a, and are further formed in order in a through hole provided in the insulating substrate 41a. The wiring layer 41b includes a plurality of wirings.

The semiconductor device 3 further includes a chip stack C mounted on the substrate 41. The chip stack C includes the plurality of memory chips 11, the plurality of memory chips 12, and the bridge chip 13 that are stacked in the Z direction. In more detail, the chip stack C includes the plurality of memory chips 12 stacked on the substrate 41, the bridge chip 13 stacked on the plurality of memory chips 12, and the plurality of memory chips 11 stacked on the bridge chip 13. Thus, the bridge chip 13 is disposed between the plurality of memory chips 11 and the plurality of memory chips 12. Meanwhile, the IF chip 14 is disposed between the substrate 41 and the chip stack C, and is attached to the chip stack C.

The bumps 42 are provided on an upper face of the IF chip 14, and are electrically connected to the IF chip 14. The bumps 43 are provided on an upper face of the substrate 41, and are electrically connected to the wiring layer 41b. The external connecting terminals 44 are provided on a lower face of the substrate 41, and are electrically connected to the wiring layer 41b. The IF chip 14 is electrically connected to the bus 5 (FIG. 1) by the plurality of external connecting terminals 44, and functions as an interface between the plurality of chips in the chip stack C and the plurality of external connecting terminals 44 under the substrate 41.

Note that the external connecting terminals 44 of the present embodiment are not in contact with the wiring layer 41b in a cross section illustrated in FIG. 2, but are in contact with the wiring layer 41b in a cross section different from the cross section illustrated in FIG. 2. As a result, the external connecting terminals 44 of the present embodiment are electrically connected to the wiring layer 41b. The external connecting terminals 44 are, for example, solder balls.

The wirings 51 are provided under the chip stack C, and are disposed between the substrate 41 and the chip stack C. FIG. 2 illustrates the shape of the wirings 51 by the thick line. The wirings 51 are disposed on the corresponding bumps 43, and are electrically connected to the corresponding external connecting terminals 44 via the bumps 43 and the wiring layer 41b. The wirings 51 are electrically connected to the chip stack C, the IF chip 14, and the corresponding external connecting terminals 44. In FIG. 2, the chip stack C is disposed above the substrate 41 through intermediation of the plurality of bumps 43 and the plurality of wirings 51.

Note that the wirings 51 may be provided outside of the chip stack C or inside of the chip stack C. In the former case, the wirings 51 may be attached to a lower face of the memory chip 12 in the lowermost layer of the chip stack C. In the latter case, the wirings 51 may be a part of a multilayer wiring structure in the memory chip 12 in the lowermost layer of the chip stack C.

The resin layer 52 is formed to cover a surface of the chip stack C. The resin layer 53 is formed to cover a surface of the resin layer 52. Parts of the resin layers 52 and 53 are formed between the substrate 41 and the chip stack C. Further, a part of the resin layer 53 is formed around the IF chip 14 and the bumps 42 and 43.

The chip stack C includes the through electrodes 21 to 26. The through electrodes 21 to 26 pass through one or more chips in the chip stack C in the Z direction. The through electrode 21 is provided to electrically connect the plurality of memory chips 11 and the IF chip 14. The through electrode 22 is provided to electrically connect the plurality of memory chips 12 and the IF chip 14. The through electrode 23 is provided to electrically connect the bridge chip 13 and the IF chip 14. The through electrode 24 is provided to electrically connect the plurality of memory chips 11 and the bridge chip 13. The through electrode 25 is provided to electrically connect the plurality of memory chips 12 and the bridge chip 13. The through electrodes 26 are provided to electrically connect the corresponding external connecting terminals 44 and the plurality of memory chips 11, the plurality of memory chips 12, and the bridge chip 13. The through electrodes 26 are disposed on the corresponding wirings 51, and are electrically connected to the IF chip 14 and the external connecting terminals 44 via the wirings 51.

The IF chip 14 includes the metal pads 31 to 34 on the upper face of the IF chip 14. The metal pad 31 is electrically connected to the through electrode 21 by the bump 42. The metal pad 32 is electrically connected to the through electrode 22 by the bump 42. The metal pad 33 is electrically connected to the through electrode 23 by the bump 42. The IF chip 14 illustrated in FIG. 2 includes a plurality of metal pads 34. The metal pads 34 are electrically connected to the corresponding wirings 51 by the bumps 42, and thus are electrically connected to the corresponding through electrodes 26 and the corresponding external connecting terminals 44.

As described above, the memory chips 11 and 12 of the present embodiment are mounted on the substrate 41 in the form of the chip stack C. This makes it possible to reduce the area of the semiconductor device 3 in plan view, and to downsize the semiconductor device 3.

Further, the bridge chip 13 of the present embodiment is disposed between the plurality of memory chips 11 and the plurality of memory chips 12 as a part of the chip stack C. This makes it possible to execute data transfer between the memory chips 11 and 12 having types different from each other in the semiconductor package P by the bridge chip 13, and to prevent the area of the semiconductor device 3 from increasing due to the bridge chip 13.

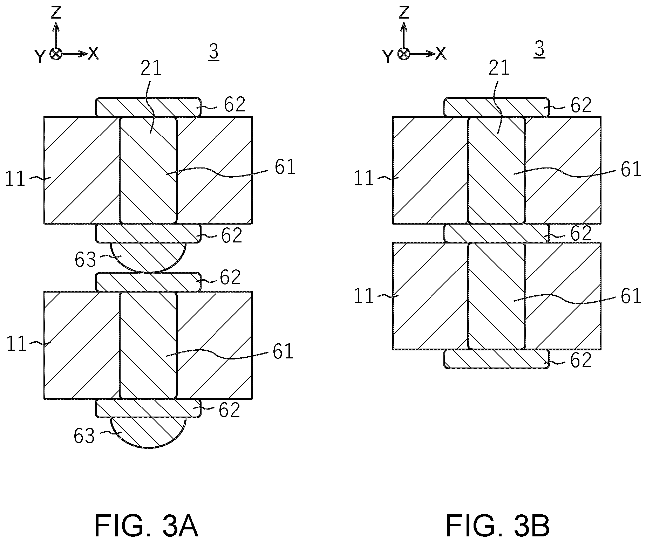

FIGS. 3A and 3B are sectional views illustrating two examples of the structure of the semiconductor device 3 of the first embodiment.

FIG. 3A illustrates a first example of the semiconductor device 3 of the present embodiment. In the first example, the through electrode 21 includes a plurality of electrodes 61, a plurality of pads 62, and a plurality of bumps 63. Each electrode 61 passes through one chip (the memory chip 11 in FIG. 3A) in the chip stack C. Each pad 62 is provided on an upper face or a lower face of one electrode 61. Each bump 63 is provided between the pad 62 provided on the upper face of one electrode 61 and the pad 62 provided on the lower face of another one electrode 61, and electrically connects the former pad 62 and the latter pad 62. The above-mentioned plurality of electrodes 61 and the above-mentioned plurality of bumps 63 are alternately provided in the Z direction. Note that, in the first example, the through electrodes 22 to 26 also have structures similar to that of the through electrode 21.

FIG. 3B illustrates a second example of the semiconductor device 3 of the present embodiment. In the second example, the through electrode 21 includes a plurality of electrodes 61 and a plurality of pads 62. Each electrode 61 passes through one chip (the memory chip 11 in FIG. 3B) in the chip stack C. Each pad 62 is provided between the upper face of one electrode 61 and the lower face of another one electrode 61, and electrically connects the former electrode 61 and the latter electrode 61. Note that, in the second example, the through electrodes 22 to 26 also have structures similar to that of the through electrode 21.

Note that the through electrodes 21 to 26 illustrated in FIG. 2 have structures similar to that of the through electrode 21 of the second example, but may have structures similar to that of the through electrode 21 of the first example instead.

### [First Example]

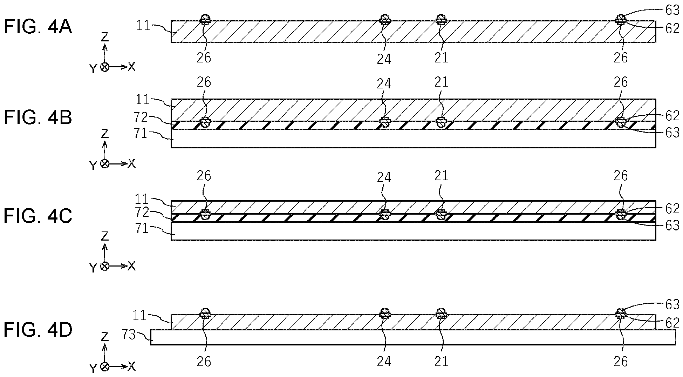

FIGS. 4A to 10 are sectional views illustrating a first example of the method of manufacturing the semiconductor device 3 of the first embodiment. In FIGS. 4A to 10, the structure of the first example illustrated in FIG. 3A is adopted.

FIGS. 4A to 4D illustrate steps of forming the memory chip 11 in the uppermost layer of the chip stack C.

First, on the memory chip 11, the pads 62 and the bumps 63 of some of the through electrodes 21 to 26 are formed (FIG. 4A). In FIG. 4A, the pads 62 and the bumps 63 of the through electrodes 21, 24, and 26 are formed on the memory chip 11.

Next, the memory chip 11 is temporarily bonded to a support substrate 71 (FIG. 4B). At this time, the memory chip 11 is placed on the support substrate 71 through intermediation of a resin layer 72. Note that the lower face of the memory chip 11 illustrated in FIG. 4B corresponds to the upper face of the memory chip 11 illustrated in FIG. 4A.

Next, the memory chip 11 is thinned (FIG. 4C). As a result, the thickness of the memory chip 11 illustrated in FIG. 4C is smaller than the thickness of the memory chip 11 illustrated in FIG. 4B.

Next, the memory chip 11 is separated from the support substrate 71, and the memory chip 11 is placed on another support substrate 73 (FIG. 4D). Note that the upper face of the memory chip 11 illustrated in FIG. 4D corresponds to the lower face of the memory chip 11 illustrated in FIG. 4C.

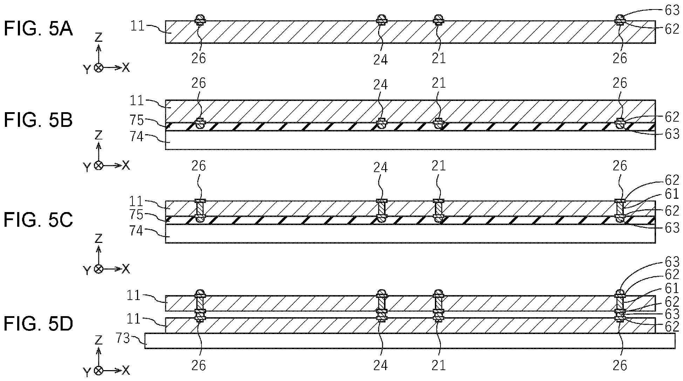

FIGS. 5A to 5D illustrate steps of forming the second memory chip 11 from the uppermost layer of the chip stack C.

First, on the memory chip 11, the pads 62 and the bumps 63 of some of the through electrodes 21 to 26 are formed (FIG. 5A). In FIG. 5A, the pads 62 and the bumps 63 of the through electrodes 21, 24, and 26 are formed on the memory chip 11.

Next, the memory chip 11 is temporarily bonded to a support substrate 74 (FIG. 5B). At this time, the memory chip 11 is placed on the support substrate 74 through intermediation of a resin layer 75. Note that the lower face of the memory chip 11 illustrated in FIG. 5B corresponds to the upper face of the memory chip 11 illustrated in FIG. 5A.

Next, the memory chip 11 is thinned (FIG. 5C). As a result, the thickness of the memory chip 11 illustrated in FIG. 5C is smaller than the thickness of the memory chip 11 illustrated in FIG. 5B.

Next, in the memory chip 11 and on the memory chip 11, the electrodes 61 and the pads 62 of some of the through electrodes 21 to 26 are formed (FIG. 5C). In FIG. 5C, the electrodes 61 and the pads 62 of the through electrodes 21, 24, and 26 are formed in the memory chip 11 and on the memory chip 11. In FIG. 5C, further, the electrodes 61 are formed on the corresponding pads 62. Note that, in the present embodiment, parts of the electrodes 61 are formed in the step of FIG. 5A, and the remaining parts of the electrodes 61 are formed in the step of FIG. 5C.

Next, the memory chip 11 is separated from the support substrate 74, and the separated memory chip 11 is stacked on the memory chip 11 placed on the support substrate 73 (FIG. 5D). As a result, two memory chips 11 are stacked on the support substrate 73. Note that the upper face of the upper memory chip 11 illustrated in FIG. 5D corresponds to the lower face of the memory chip 11 illustrated in FIG. 5C. In FIG. 5D, the pads 62 of the upper memory chip 11 are placed on the bumps 63 of the lower memory chip 11.

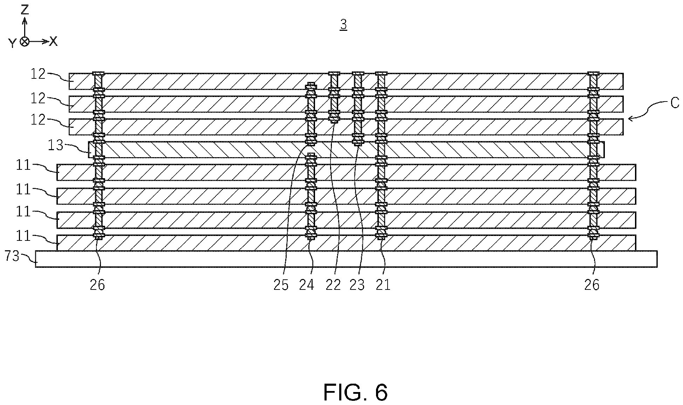

In the present embodiment, other chips of the chip stack C (the memory chips 11, the memory chips 12, and the bridge chip 13) are also formed in the steps of FIGS. 5A to 5D. As a result, the chip stack C is formed on the support substrate 74, and the through electrodes 21 to 26 are formed in the chip stack C (FIG. 6). The through electrodes 21 to 26 illustrated in FIG. 6 have the structures of the first example illustrated in FIG. 3A.

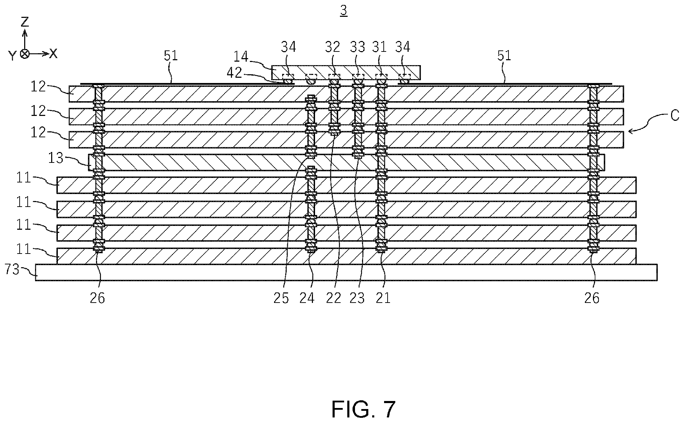

Next, the plurality of wirings 51 are formed on the chip stack C (FIG. 7). The wirings 51 are disposed on the pads 62 of the corresponding through electrodes 26.

Next, the plurality of bumps 42 are formed on the metal pads 31 to 34 of the IF chip 14, and then the IF chip 14 is placed on the chip stack C (FIG. 7). The bump 42 of the metal pad 31 is disposed on the pad 62 of the through electrode 21. The bump 42 of the metal pad 32 is disposed on the pad 62 of the through electrode 22. The bump 42 of the metal pad 33 is disposed on the pad 62 of the through electrode 23. The bumps 42 of the metal pads 34 are disposed on the corresponding wirings 51.

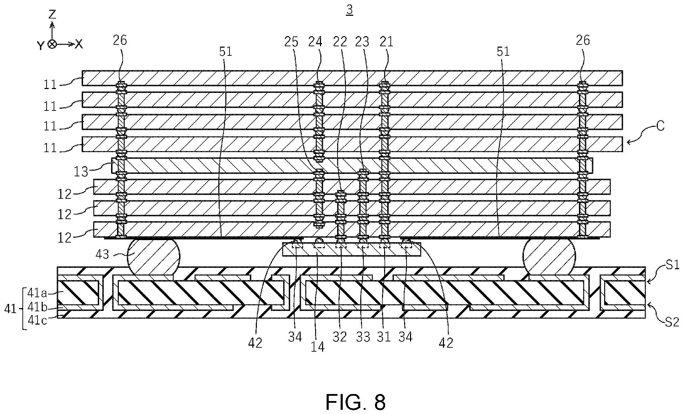

Next, the substrate 41 including the insulating substrate 41a, the wiring layer 41b, and the resin layer 41c is prepared, and the plurality of bumps 43 are formed on the wiring layer 41b of the substrate 41 (FIG. 8). Next, the chip stack C is separated from the support substrate 73, and the chip stack C is placed on the plurality of bumps 43 (FIG. 8). Note that the upper face of the chip stack C illustrated in FIG. 8 corresponds to the lower face of the chip stack C illustrated in FIG. 7. In FIG. 8, the wirings 51 are placed on the corresponding bumps 43.

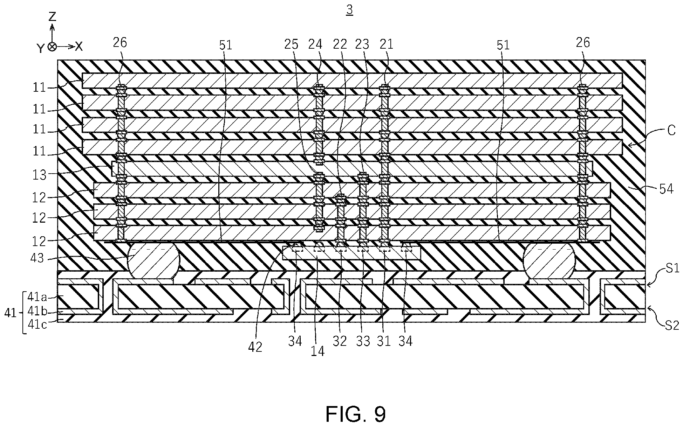

Next, a resin layer 54 is formed on the surface of the chip stack C (FIG. 9). A part of the resin layer 54 is buried between the substrate 41 and the chip stack C. In FIG. 9, the resin layer 54 is formed in place of the above-mentioned resin layers 52 and 53.

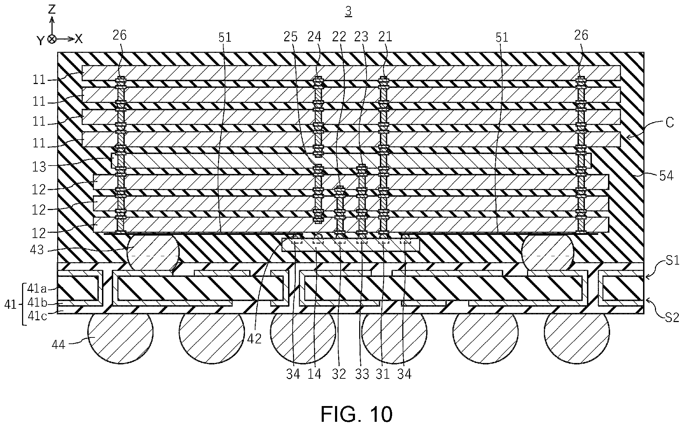

Next, the plurality of external connecting terminals 44 are formed on the lower face of the substrate 41 (FIG. 10). The external connecting terminals 44 are electrically connected to the wiring layer 41b of the substrate 41.

As described above, the semiconductor device 3 of the present embodiment having the form of the semiconductor package P is manufactured.

### [Second Example]

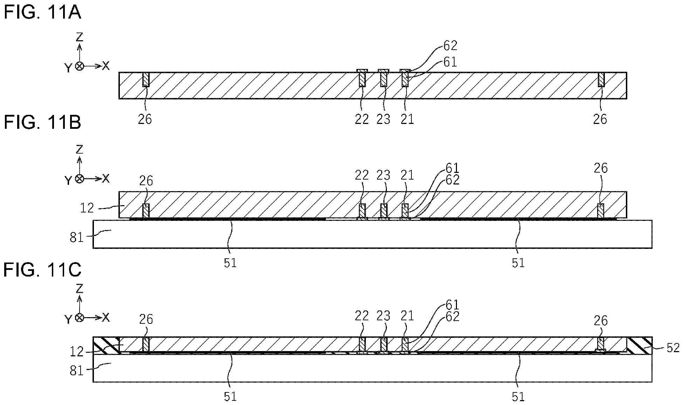

FIGS. 11A to 18 are sectional views illustrating a second example of the method of manufacturing the semiconductor device 3 of the first embodiment. In FIGS. 11A to 18, the structure of the second example illustrated in FIG. 3B is adopted.

FIGS. 11A to 11C illustrate steps of forming the memory chip 12 in the lowermost layer of the chip stack C.

First, in the memory chip 12 and on the memory chip 12, the electrodes 61 and the pads 62 of some of the through electrodes 21 to 26 are formed (FIG. 11A). In FIG. 11A, the electrodes 61 of the through electrodes 21, 22, 23, and 26 are formed in the memory chip 12, and the pads 62 of the through electrodes 21, 22, and 23 are formed on the memory chip 12. Note that the electrodes 61 illustrated in FIG. 11A are formed so as not to pass through the memory chip 12.

Next, the memory chip 12 is placed on a support substrate 81 (FIG. 11B). Note that the lower face of the memory chip 12 illustrated in FIG. 11B corresponds to the upper face of the memory chip 12 illustrated in FIG. 11A.

FIG. 11B illustrates the plurality of wirings 51 provided under the memory chip 12. In FIG. 11B, the electrodes 61 of the through electrodes 26 are disposed on the corresponding wirings 51. The wirings 51 may be provided on the upper face of the memory chip 12 during the step of FIG. 11A, or may be provided on the lower face of the memory chip 12 during the step of FIG. 11B.

Next, a part of the resin layer 52 is formed on the surface of the memory chip 12, and the resin layer 52 and the memory chip 12 are thinned (FIG. 11C). As a result, the upper face of the memory chip 12 is exposed from the resin layer 52, and the thickness of the memory chip 12 illustrated in FIG. 11C is smaller than the thickness of the memory chip 12 illustrated in FIG. 11B. Moreover, the upper faces of the electrodes 61 are exposed from the memory chip 12, and the electrodes 61 pass through the memory chip 12.

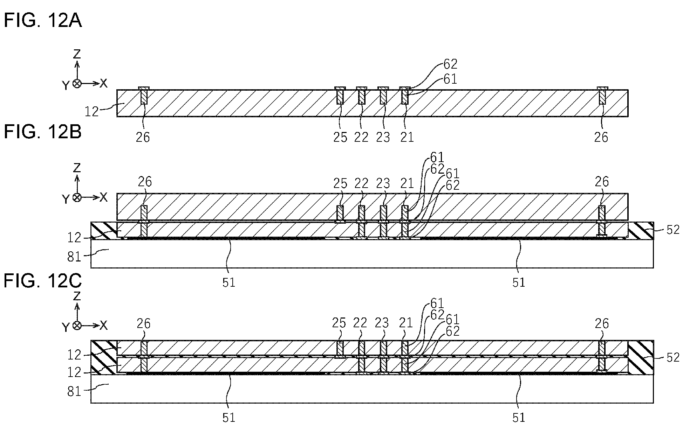

FIGS. 12A to 12C illustrate steps of forming the second memory chip 12 from the lowermost layer of the chip stack C.

First, in the memory chip 12 and on the memory chip 12, the electrodes 61 and the pads 62 of some of the through electrodes 21 to 26 are formed (FIG. 12A). In FIG. 12A, the electrodes 61 of the through electrodes 21, 22, 23, 25, and 26 are formed in the memory chip 12, and the pads 62 of the through electrodes 21, 22, 23, 25, and 26 are formed on the memory chip 12. Note that the electrodes 61 illustrated in FIG. 12A are formed so as not to pass through the memory chip 12.

Next, the memory chip 12 prepared in the step of FIG. 12A is stacked on the memory chip 12 placed on the support substrate 81 (FIG. 12B). Note that the lower face of the upper memory chip 12 illustrated in FIG. 12B corresponds to the upper face of the memory chip 12 illustrated in FIG. 12A. In FIG. 12B, the pads 62 of the through electrodes 21, 22, 23, and 26 of the upper memory chip 11 are placed on the electrodes 61 of the through electrodes 21, 22, 23, and 26 of the lower memory chip 12.

Next, a part of the resin layer 52 is formed on the surface of the upper memory chip 12, and the resin layer 52 and the upper memory chip 12 are thinned (FIG. 12C). As a result, the upper face of the upper memory chip 12 is exposed from the resin layer 52, and the thickness of the upper memory chip 12 illustrated in FIG. 12C is smaller than the thickness of the upper memory chip 12 illustrated in FIG. 12B. Moreover, the upper faces of the electrodes 61 of the upper memory chip 12 are exposed from the upper memory chip 12, and the electrodes 61 of the upper memory chip 12 pass through the upper memory chip 12.

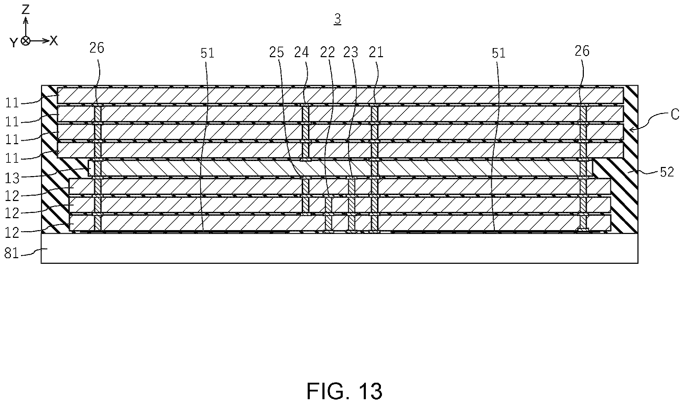

In the present embodiment, other chips of the chip stack C (the memory chips 11, the memory chip 12, and the bridge chip 13) are also formed in the steps of FIGS. 12A to 12C. As a result, the chip stack C is formed on the support substrate 81, and the through electrodes 21 to 26 are formed in the chip stack C (FIG. 13). The through electrodes 21 to 26 illustrated in FIG. 13 have the structures of the second example illustrated in FIG. 3B. Note that, in the step of FIG. 13, a part of the resin layer 52 is formed also on the upper face of the memory chip 11 in the uppermost layer of the chip stack C.

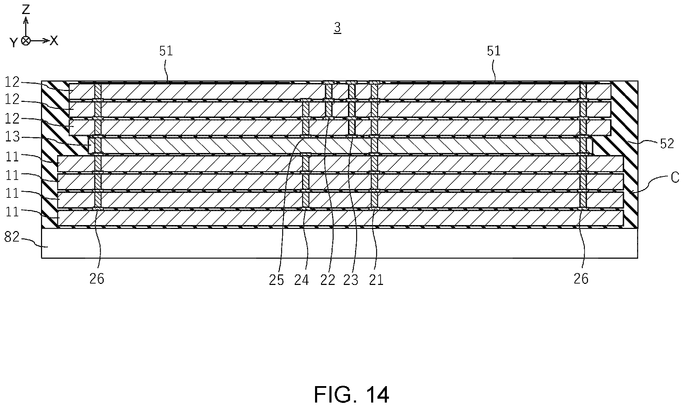

Next, the chip stack C is separated from the support substrate 81 together with the wirings 51 and the resin layer 52, and the chip stack C and the like are placed on another support substrate 82 (FIG. 14). Note that the upper face of the chip stack C illustrated in FIG. 14 corresponds to the lower face of the chip stack C illustrated in FIG. 13.

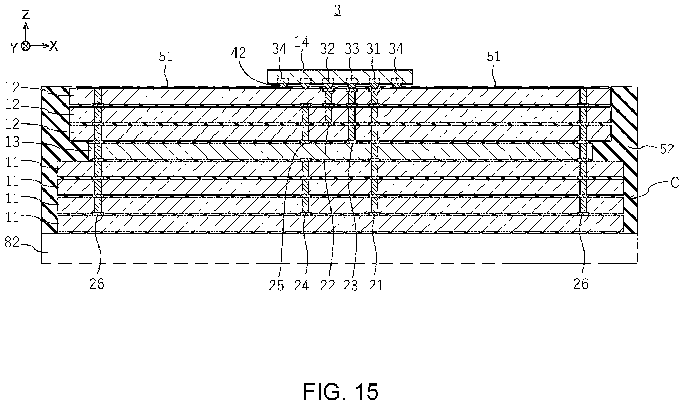

Next, the plurality of bumps 42 are formed on the metal pads 31 to 34 of the IF chip 14, and then the IF chip 14 is placed on the chip stack C (FIG. 15). The bump 42 of the metal pad 31 is disposed on the pad 62 of the through electrode 21. The bump 42 of the metal pad 32 is disposed on the pad 62 of the through electrode 22. The bump 42 of the metal pad 33 is disposed on the pad 62 of the through electrode 23. The bumps 42 of the metal pads 34 are disposed on the corresponding wirings 51.

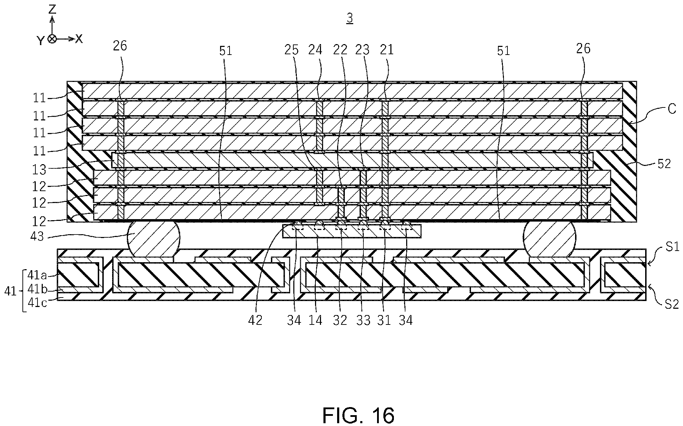

Next, the substrate 41 including the insulating substrate 41a, the wiring layer 41b, and the resin layer 41c is prepared, and the plurality of bumps 43 are formed on the wiring layer 41b of the substrate 41 (FIG. 16). Next, the chip stack C is separated from the support substrate 82, and the chip stack C is placed on the plurality of bumps 43 (FIG. 16). Note that the upper face of the chip stack C illustrated in FIG. 16 corresponds to the lower face of the chip stack C illustrated in FIG. 15. In FIG. 16, the wirings 51 are placed on the corresponding bumps 43.

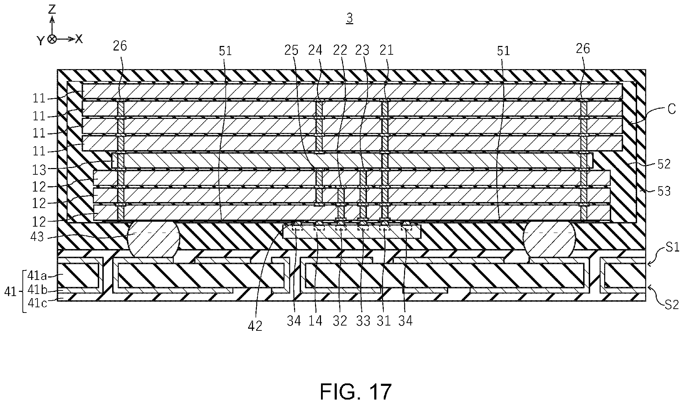

Next, the resin layer 53 is formed on the surface of the resin layer 52 (FIG. 17). A part of the resin layer 53 is buried between the substrate 41 and the resin layer 52.

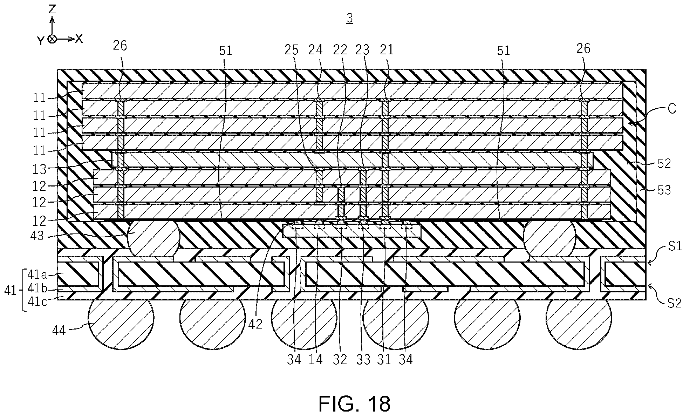

Next, the plurality of external connecting terminals 44 are formed on the lower face of the substrate 41 (FIG. 18). The external connecting terminals 44 are electrically connected to the wiring layer 41b of the substrate 41.

As described above, the semiconductor device 3 of the present embodiment having the form of the semiconductor package P is manufactured.

As described above, the semiconductor device 3 of the present embodiment includes the memory chips 11 and 12 having types different from each other, and the bridge chip 13 that electrically connects the memory chips 11 and 12. Moreover, the semiconductor device 3 of the present embodiment includes the chip stack C including the memory chips 11 and 12 and the bridge chip 13 that are stacked on the substrate 41.

Thus, the present embodiment makes it possible to mount the memory chips 11 and 12 of plural types on the substrate 41 in a suitable mode. For example, the area of the semiconductor device 3 in plan view can be reduced, and the semiconductor device 3 can be downsized. Moreover, data transfer between the memory chips 11 and 12 having types different from each other can be executed by the bridge chip 13, and the area of the semiconductor device 3 can be prevented from increasing due to the bridge chip 13.

### (Second Embodiment)

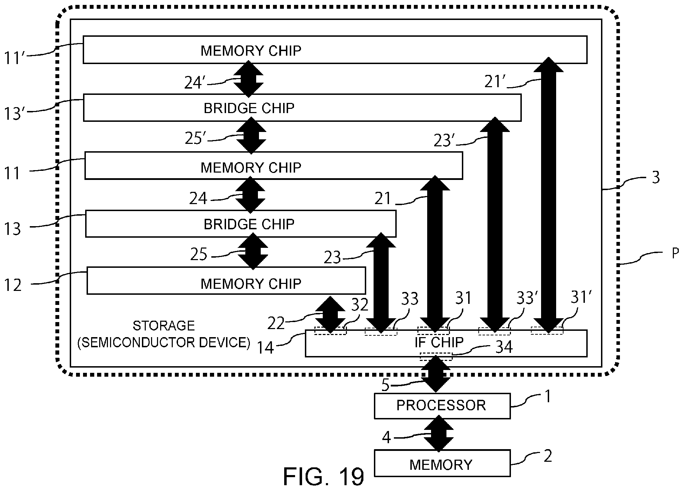

FIG. 19 is a block diagram illustrating a configuration of an information processing device of a second embodiment.

The information processing device (FIG. 19) of the present embodiment includes components similar to those of the information processing device (FIG. 1) of the first embodiment. However, the storage 3 of the present embodiment further includes a memory chip 11' and a bridge chip 13'. The memory chip 11' is an example of a third memory chip. The bridge chip 13' is an example of a second bridge chip.

The memory chips 11', 11, and 12 have types different from each other. For example, the memory chips 11', 11, and 12 are different in at least one of a data retaining method, a memory capacity, and an access speed. The memory chip 11' is, for example, a non-volatile memory such as a flash memory. The memory chip 11 is, for example, a non-volatile memory such as a storage-class memory. The memory chip 12 is, for example, a volatile memory such as a DRAM (Dynamic Random Access Memory). In this case, the data retaining methods (non-volatile) of the memory chips 11' and 11 are the same, and the data retaining method (volatile) of the memory chip 12 is different from that of the memory chips 11' and 11. Further, the memory chip 11' has a large capacity, the memory chip 11 has a small capacity, and the memory chip 12 has a further smaller capacity. Accordingly, the memory capacities of the memory chips 11', 11, and 12 are different. Further, the access speed of the memory chip 11' is low, the access speed of the memory chip 11 is high, and the access speed of the memory chip 12 is further higher. Accordingly, the access speeds of the memory chips 11', 11, and 12 are different. Each of the memory chips 11', 11, and 12 includes, for example, a memory cell array including a plurality of memory cells, and a circuit (for example, a CMOS circuit) including a plurality of transistors that control the plurality of memory cells.

The bridge chip 13' is disposed between the memory chip 11' and the memory chip 11 to electrically connect the memory chip 11' and the memory chip 11. The bridge chip 13' has a function of transferring data between memory chips that have types different from each other. In the present embodiment, the type of the memory chip 11 is different from the type of the memory chip 11', and hence the bridge chip 13' is disposed between the memory chip 11' and the memory chip 11. The bridge chip 13' transfers data from one of the memory chips 11' and 11 to the other of the memory chips 11' and 11.

In the present embodiment, the IF chip 14 is electrically connected to the memory chips 11', 11, and 12, the bridge chips 13' and 13, and the bus 5 (processor 1). The IF chip 14 functions as an interface between each of the memory chips 11', 11, and 12 and the bridge chips 13' and 13 and the bus 5 (the processor 1). For example, the IF chip 14 receives a signal from the processor 1, and accesses any one of the memory chips 11', 11, and 12 and the bridge chips 13' and 13 based on this signal. As an example, the IF chip 14 transmits a command to the bridge chip 13', and the bridge chip 13' transfers data from the memory chip 11 to the memory chip 11' based on this command. In this manner, this data can be transferred from the memory chip 11 to the memory chip 11' without temporarily storing this data into the memory 2. An example of such a command is a write command for use in writing data to the memory chip 11'.

Similarly to the first embodiment, the storage 3 of the present embodiment is used when, for example, information processing for an AI is executed by the processor 1. The present embodiment makes it possible to execute information processing at high speed by transferring data among the memory chips 11', 11, and 12 without going through the memory 2. Examples of such information processing include information processing regarding inference of the AI.

Similarly to the first embodiment, the storage 3 of the present embodiment is a semiconductor device having a form of a semiconductor package P. The memory chips 11', 11, and 12, the bridge chips 13' and 13, and the IF chip 14 of the present embodiment are mounted on the substrate 41 described above, and form a part of the semiconductor package P.

The storage 3 of the present embodiment includes, in addition to the through electrodes 21 to 25, a through electrode 21', a through electrode 23', a through electrode 24', and a through electrode 25'. Further, the IF chip 14 of the present embodiment includes, in addition to the metal pads 31 to 34, a metal pad 31' and a metal pad 33'. The through electrodes 21', 23', 24', and 25' and the metal pads 31' and 33' also form a part of the semiconductor package P.

The through electrode 21' is provided to electrically connect the memory chip 11' and the IF chip 14. The through electrode 23' is provided to electrically connect the bridge chip 13' and the IF chip 14. The IF chip 14 can use the through electrode 21' to access the memory chip 11', and use the through electrode 23' to access the bridge chip 13'.

The through electrode 24' is provided to electrically connect the memory chip 11' and the bridge chip 13'. The through electrode 25' is provided to electrically connect the memory chip 11 and the bridge chip 13'. The bridge chip 13' can use the through electrodes 24' and 25' to transfer data from one of the memory chips 11' and 11 to the other of the memory chips 11' and 11.

The metal pad 31' is electrically connected to the through electrode 21'. The metal pad 33' is electrically connected to the through electrode 23'. The IF chip 14 can use the metal pad 31' to access the memory chip 11', and use the metal pad 33' to access the bridge chip 13'.

The present embodiment makes it possible to accommodate and use, with the bridge chips 13' and 13 and the IF chip 14 being adopted, the memory chips 11', 11, and 12 having types different from each other in the same semiconductor package P. This makes it possible to reduce a total area of the storage 3 on a mother board of the information processing device of the present embodiment, and makes it possible to downsize the information processing device of the present embodiment. Thus, the storage 3 of the present embodiment is suitable for, for example, mobile equipment such as a smart phone.

Hereinafter, further details of the storage 3 of the present embodiment are described. In the following description, the storage 3 of the present embodiment is also referred to as "semiconductor device 3".

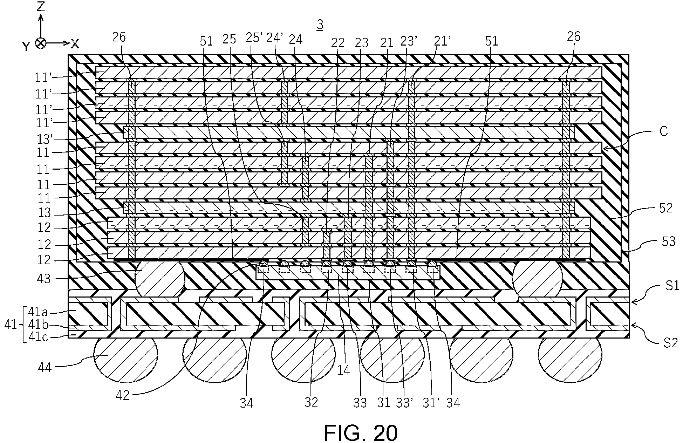

FIG. 20 is a sectional view illustrating the structure of the semiconductor device 3 of the second embodiment.

The semiconductor device 3 (FIG. 20) of the present embodiment includes components similar to those of the semiconductor device 3 (FIG. 2) of the first embodiment. However, the semiconductor device 3 of the present embodiment further includes, as illustrated in FIG. 20, a plurality of memory chips 11'. The memory chips 11' illustrated in FIG. 20 correspond to the memory chip 11' illustrated in FIG. 19, and have structures and functions similar to those of the memory chip 11' illustrated in FIG. 19. The semiconductor device 3 of the present embodiment further includes, as described above with FIG. 19, the bridge chip 13', the through electrodes 21', 23', 24', and 25', and the metal pads 31' and 33'.

The chip stack C of the present embodiment includes the plurality of memory chips 11', the plurality of memory chips 11, the plurality of memory chips 12, the bridge chip 13', and the bridge chip 13 that are stacked in the Z direction. In more detail, the chip stack C of the present embodiment includes the plurality of memory chips 12 stacked on the substrate 41, the bridge chip 13 stacked on the plurality of memory chips 12, the plurality of memory chips 11 stacked on the bridge chip 13, the bridge chip 13' stacked on the plurality of memory chips 11, and the plurality of memory chips 11' stacked on the bridge chip 13'. Thus, the bridge chip 13' is disposed between the plurality of memory chips 11' and the plurality of memory chips 11, and the bridge chip 13 is disposed between the plurality of memory chips 11 and the plurality of memory chips 12.

The chip stack C of the present embodiment includes the through electrodes 21', 23', 24', and 25'. The through electrodes 21', 23', 24', and 25' pass through one or more chips in the chip stack C in the Z direction. The through electrode 21' is provided to electrically connect the plurality of memory chips 11' and the IF chip 14. The through electrode 23' is provided to electrically connect the bridge chip 13' and the IF chip 14. The through electrode 24' is provided to electrically connect the plurality of memory chips 11' and the bridge chip 13'. The through electrode 25' is provided to electrically connect the plurality of memory chips 11 and the bridge chip 13'.

The IF chip 14 of the present embodiment includes the metal pads 31' and 33' on the upper face of the IF chip 14. The metal pad 31' is electrically connected to the through electrode 21' by the bump 42. The metal pad 33' is electrically connected to the through electrode 23' by the bump 42.

As described above, the memory chips 11', 11, and 12 of the present embodiment are mounted on the substrate 41 in the form of the chip stack C. This makes it possible to reduce the area of the semiconductor device 3 in plan view, and to downsize the semiconductor device 3.

Further, the bridge chips 13' and 13 of the present embodiment are disposed between the plurality of memory chips 11' and the plurality of memory chips 11 and between the plurality of memory chips 11 and the plurality of memory chips 12, as a part of the chip stack C. This makes it possible to execute data transfer among the memory chips 11', 11, and 12 having types different from each other by the bridge chips 13' and 13, and to prevent the area of the semiconductor device 3 from increasing due to the bridge chips 13' and 13.

Note that the through electrodes 21', 23', 24', and 25' illustrated in FIG. 20 have structures similar to that of the through electrode 21 of the second example illustrated in FIG. 3B, but may have structures similar to that of the through electrode 21 of the first example illustrated in FIG. 3A instead. When the semiconductor device 3 of the present embodiment is manufactured as in the first example illustrated in FIGS. 4A to 10, the step illustrated in FIG. 6 is applied also to the memory chips 11' and the bridge chip 13'. Meanwhile, when the semiconductor device 3 of the present embodiment is manufactured as in the second example illustrated in FIGS. 11A to 18, the step illustrated in FIG. 13 is applied also to the memory chips 11' and the bridge chip 13'.

As described above, the semiconductor device 3 of the present embodiment includes the memory chips 11', 11, and 12 having types different from each other, and the bridge chips 13' and 13 that electrically connect the memory chips 11', 11, and 12. Moreover, the semiconductor device 3 of the present embodiment includes the chip stack C including the memory chips 11', 11, and 12 and the bridge chips 13' and 13 that are stacked on the substrate 41.

Thus, the present embodiment makes it possible to mount, similarly to the first embodiment, the memory chips 11', 11, and 12 of plural types on the substrate 41 in a suitable mode.

Note that the semiconductor device 3 of the first or second embodiment may include, in FIG. 1 or FIG. 19, N+1 memory chips having types different from each other, and N bridge chips ("N" is an integer of 3 or more) that electrically connect those N+1 memory chips. When such a configuration is applied to FIG. 2 or FIG. 20, the semiconductor device 3 of the first or second embodiment may include a plurality of memory chips of the same type. In other words, the semiconductor device 3 of the first or second embodiment may include, in FIG. 2 or FIG. 20, memory chips of N+1 types, and N bridge chips that electrically connect those memory chips of N+1 types. In this case, each bridge chip is disposed between one or more memory chips of one type and one or more memory chips of another type. When the number of memory chips in the semiconductor device 3 in this case is represented by "K", the relationship of K≥N+1 is satisfied between "N" and "K".

Further, the semiconductor device 3 of the first embodiment may include, similarly to the semiconductor device 3 of the second embodiment, both of a non-volatile memory chip and a volatile memory chip. Conversely, the semiconductor device 3 of the second embodiment may include only a non-volatile memory chip similarly to the semiconductor device 3 of the first embodiment.

### (Third Embodiment)

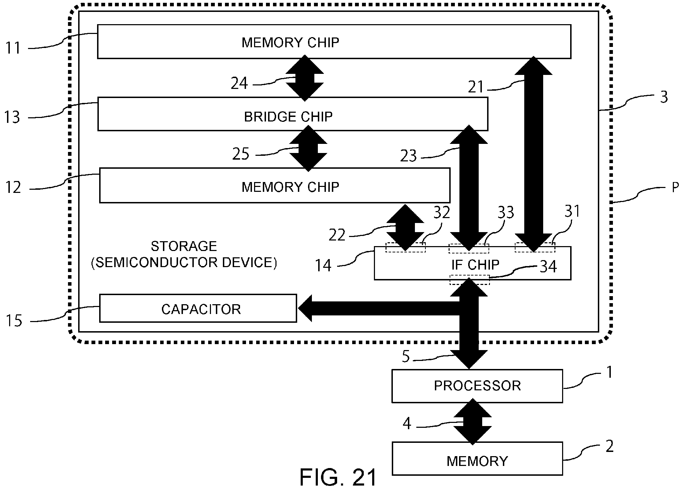

FIG. 21 is a block diagram illustrating a configuration of an information processing device of a third embodiment.

The information processing device (FIG. 21) of the present embodiment includes components similar to those of the information processing device (FIG. 1) of the first embodiment. However, the storage 3 of the present embodiment further includes a capacitor 15. In FIG. 21, the capacitor 15 is electrically connected to the metal pad 34 of the IF chip 14. Examples of the capacitor 15 include thin capacitors such as a silicon capacitor.

Hereinafter, further details of the storage 3 of the present embodiment are described. In the following description, the storage 3 of the present embodiment is also referred to as "semiconductor device 3".

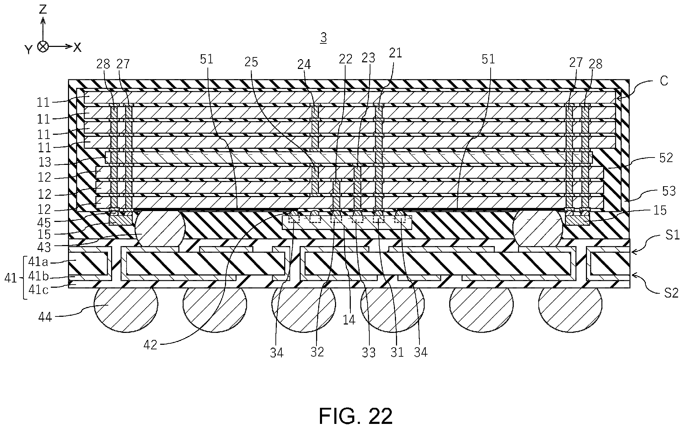

FIG. 22 is a sectional view illustrating the structure of the semiconductor device 3 of the third embodiment.

The semiconductor device 3 (FIG. 22) of the present embodiment includes components similar to those of the semiconductor device 3 (FIG. 2) of the first embodiment. However, the semiconductor device 3 of the present embodiment further includes, as illustrated in FIG. 22, a plurality of capacitors 15. The capacitors 15 illustrated in FIG. 22 correspond to the capacitor 15 illustrated in FIG. 21, and have structures and functions similar to those of the capacitor 15 illustrated in FIG. 21.

The semiconductor device 3 of the present embodiment further includes a plurality of through electrodes 27, a plurality of through electrodes 28, and a plurality of bumps 45. The through electrodes 27 are an example of a seventh electrode. The through electrodes 28 are an example of an eighth electrode. Note that illustration of the through electrode 26 is omitted in FIG. 22. The through electrodes 27 and 28 are provided in the chip stack C similarly to the through electrodes 21 to 26. The through electrode 26 is provided in, for example, an XZ cross section different from the XZ cross section illustrated in FIG. 22.

The through electrodes 27 are electrically connected to the plurality of memory chips 11, the plurality of memory chips 12, the bridge chip 13, and the IF chip 14. The through electrodes 27 are further electrically connected to the corresponding capacitors 15. The through electrodes 27 of the present embodiment are, for example, power supply wirings (VDD interconnects).

The through electrodes 28 are electrically connected to the plurality of memory chips 11, the plurality of memory chips 12, and the bridge chip 13. The through electrodes 28 are further electrically connected to the corresponding capacitors 15. The through electrodes 28 of the present embodiment are, for example, ground wirings (GND interconnects).

The bumps 45 are provided on upper faces of the corresponding capacitors 15. In FIG. 22, the plurality of bumps 45 are provided on the upper faces of the respective capacitors 15. Specifically, on the upper face of each capacitor 15, the bump 45 that electrically connects the capacitor 15 and the through electrode 27 and the bump 45 that electrically connects the capacitor 15 and the through electrode 28 are provided.

The capacitors 15 are electrically connected to the corresponding through electrodes 27 via the bumps 45, and are electrically connected to the corresponding through electrodes 28 via the bumps 45. Each capacitor 15 includes two capacitor electrodes (not shown). One capacitor electrode is electrically connected to the through electrode 27 and the IF chip 14, and the other capacitor electrode is electrically connected to the through electrode 28. With the capacitors 15 of the present embodiment, noise between the through electrode 27 (the power supply wiring) and the through electrode 28 (the ground wiring) can be reduced.

FIG. 22 illustrates the plurality of wirings 51 similarly to FIG. 2. The plurality of wirings 51 illustrated in FIG. 22 include a wiring 51 electrically connected to the through electrode 27 for the left capacitor 15 of FIG. 22, and a wiring 51 electrically connected to the through electrode 27 for the right capacitor 15 of FIG. 22. The through electrode 27 for the left capacitor 15 is electrically connected to the IF chip 14 via the former wiring 51, and the through electrode 27 for the right capacitor 15 is electrically connected to the IF chip 14 via the latter wiring 51. Note that illustration of the through electrode 26 and illustration of the wiring 51 for the through electrode 26 are omitted in FIG. 22. The wiring 51 for the through electrode 26 is provided in, for example, a XZ cross section different from the XZ cross section illustrated in FIG. 22.

In FIG. 22, the wirings 51 are provided under the chip stack C, and are disposed between the substrate 41 and the chip stack C. The wirings 51 are disposed on the corresponding bumps 43, and are electrically connected to the corresponding external connecting terminals 44 via the bumps 43 and the wiring layer 41b. The wirings 51 are electrically connected to the chip stack C, the IF chip 14, and the corresponding external connecting terminals 44. Details of the wirings 51 illustrated in FIG. 22 are substantially similar to the details of the wirings 51 illustrated in FIG. 2.

In FIG. 22, the capacitors 15 are provided under the chip stack C, and are disposed between the substrate 41 and the chip stack C. The capacitors 15 are attached to lower faces of the through electrodes 27 and 28 via the bumps 45.

Note that the through electrodes 27 and 28 illustrated in FIG. 22 have structures similar to that of the through electrode 21 of the second example illustrated in FIG. 3B, but may have structures similar to that of the through electrode 21 of the first example illustrated in FIG. 3A instead. When the semiconductor device 3 of the present embodiment is manufactured as in the first example illustrated in FIGS. 4A to 10, the capacitors 15 are placed on the chip stack C in the step illustrated in FIG. 7. Meanwhile, when the semiconductor device 3 of the present embodiment is manufactured as in the second example illustrated in FIGS. 11A to 18, the capacitors 15 are placed on the chip stack C in the step illustrated in FIG. 15.

As described above, the semiconductor device 3 of the present embodiment includes the memory chips 11 and 12 having types different from each other, and the bridge chip 13 that electrically connects the memory chips 11 and 12. Moreover, the semiconductor device 3 of the present embodiment includes the chip stack C including the memory chips 11 and 12 and the bridge chip 13 that are stacked on the substrate 41. Further, the semiconductor device 3 of the present embodiment includes the capacitor 15 between the through electrode 27 and the through electrode 28.

Thus, the present embodiment makes it possible to mount, similarly to the first embodiment, the memory chips 11 and 12 of plural types on the substrate 41 in a suitable mode. Further, the present embodiment makes it possible to reduce the noise between the through electrode 27 and the through electrode 28 by the capacitor 15.

Note that the capacitor 15 of the present embodiment may be applied to the semiconductor device 3 of the second embodiment instead of being applied to the semiconductor device 3 of the first embodiment. Further, the capacitor 15 of the present embodiment may be disposed at a position other than the position illustrated in FIG. 22.

Various embodiments are in accordance with the following numbered clauses.

Clause 1. A semiconductor device comprising:
a substrate; and
a chip stack including a plurality of chips stacked on the substrate,
wherein the plurality of chips include:
   a first memory chip;
   a second memory chip, a type of the second memory chip being different from a type of the first memory chip; and
   a first bridge chip that electrically connects the first memory chip and the second memory chip.

Clause 2. The device of Clause 1, wherein
the first memory chip is disposed above the substrate,
the second memory chip is disposed between the substrate and the first memory chip, and
the first bridge chip is disposed between the first memory chip and the second memory chip, and configured to transfer data between the first memory chip and the second memory chip.

Clause 3. The device of Clause 1 or 2, wherein the first memory chip and the second memory chip are different in at least one of a data retaining method, a memory capacity, and an access speed.

Clause 4. The device of any one of Clauses 1 to 3, wherein a memory capacity of the first memory chip is larger than a memory capacity of the second memory chip, and an access speed of the first memory chip is lower than an access speed of the second memory chip.

Clause 5. The device of any one of Clauses 1 to 4, further comprising:
an external connecting terminal provided under the substrate; and
an IF (interface) chip disposed between the substrate and the chip stack, electrically connected to the first memory chip, the second memory chip, the first bridge chip and the external connecting terminal, and configured to function as an interface between the first memory chip, the second memory chip, and the first bridge chip and the external connecting terminal.

Clause 6. The device of Clause 5, wherein the chip stack includes:
a first electrode that electrically connects the first memory chip and the IF chip;
a second electrode that electrically connects the second memory chip and the IF chip;
a third electrode that electrically connects the first bridge chip and the IF chip;
a fourth electrode that electrically connects the first memory chip and the first bridge chip;
a fifth electrode that electrically connects the second memory chip and the first bridge chip; and
a sixth electrode that electrically connects the first memory chip, the second memory chip, and the first bridge chip and the external connecting terminal.

Clause 7. The device of Clause 6, wherein
one of the first to sixth electrodes includes a plurality of electrodes respectively provided in the plurality of chips, and a plurality of bumps provided alternately with the plurality of electrodes; and
one of the plurality of electrodes and one of the plurality of bumps are electrically connected via a pad.

Clause 8. The device of Clause 6, wherein
one of the first to sixth electrodes includes a plurality of electrodes respectively provided in the plurality of chips; and
one of the plurality of electrodes and another one of the plurality of electrodes are electrically connected via a pad.

Clause 9. The device of Clause 6, 7 or 8, further comprising a wiring provided under the chip stack, and electrically connected to the sixth electrode, the IF chip, and the external connecting terminal.

Clause 10. The device of Clause 9, further comprising a bump provided under the wiring, and electrically connecting the wiring and the external connecting terminal,
wherein the bump is electrically connected to the external connecting terminal via a wiring layer in the substrate.

Clause 11. The device of any one of Clauses 6 to 10, wherein the IF chip includes:
a first pad electrically connected to the first electrode;
a second pad electrically connected to the second electrode;
a third pad electrically connected to the third electrode; and
a fourth pad electrically connected to the external connecting terminal.

Clause 12. The device of Clause 11, further comprising a wiring provided under the chip stack, and electrically connected to the sixth electrode, the fourth pad, and the external connecting terminal.

Clause 13. The device of any one of Clauses 1 to 12, wherein the plurality of chips further include:
a third memory chip, a type of the third memory chip being different from the type of the first memory chip and the type of the second memory chip; and
a second bridge chip that electrically connects the first memory chip and the third memory chip.

Clause 14. The device of Clause 13, wherein
the third memory chip is disposed above the substrate;
the first memory chip is disposed between the substrate and the third memory chip;
the second memory chip is disposed between the substrate and the first memory chip;
the first bridge chip is disposed between the first memory chip and the second memory chip, and configured to transfer data between the first memory chip and the second memory chip; and
the second bridge chip is disposed between the first memory chip and the third memory chip, and configured to transfer data between the first memory chip and the third memory chip.

Clause 15. The device of Clause 13 or 14, wherein the first memory chip, the second memory chip, and the third memory chip are different in at least one of a data retaining method, a memory capacity, and an access speed.

Clause 16. The device of Clause 5 or any Clause dependent thereon, wherein the chip stack includes:
a seventh electrode electrically connected to the first memory chip, the second memory chip, the first bridge chip, and the IF chip; and
an eighth electrode electrically connected to the first memory chip, the second memory chip, and the first bridge chip,
wherein the device further comprises a capacitor electrically connected to the seventh electrode and the eighth electrode.

Clause 17. The device of Clause 16, further comprising a wiring provided under the chip stack, and electrically connected to the seventh electrode, the IF chip, and the external connecting terminal.

Clause 18. The device of Clause 16 or 17, wherein the seventh electrode is a power supply wiring, and the eighth electrode is a ground wiring.

Clause 19. A semiconductor device comprising:
a first memory chip;
a second memory chip, a type of the second memory chip being different from a type of the first memory chip; and
a first bridge chip that electrically connects the first memory chip and the second memory chip, and is configured to transfer data between the first memory chip and the second memory chip.

Clause 20. The device of Clause 19, further comprising:
a third memory chip, a type of the third memory chip being different from the type of the first memory chip and the type of the second memory chip; and
a second bridge chip that electrically connects the first memory chip and the third memory chip, and is configured to transfer data between the first memory chip and the third memory chip.

While certain embodiments have been described, these embodiments have been presented by way of example only, and are not intended to limit the scope of the inventions. Indeed, the novel devices described herein may be embodied in a variety of other forms; furthermore, various omissions, substitutions and changes in the form of the devices described herein may be made without departing from the scope of the inventions. The accompanying claims are intended to cover such forms or modifications as would fall within the scope of the inventions.

## Claims

1. A semiconductor device comprising:
a substrate; and
a chip stack including a plurality of chips stacked on the substrate,
wherein the plurality of chips include:
a first memory chip;
a second memory chip, a type of the second memory chip being different from a type of the first memory chip; and
a first bridge chip that electrically connects the first memory chip and the second memory chip.

2. The device of Claim 1, wherein
the first memory chip is disposed above the substrate,
the second memory chip is disposed between the substrate and the first memory chip, and
the first bridge chip is disposed between the first memory chip and the second memory chip, and configured to transfer data between the first memory chip and the second memory chip.

3. The device of Claim 1 or 2, wherein the first memory chip and the second memory chip are different in at least one of a data retaining method, a memory capacity, and an access speed.

4. The device of any preceding Claim, wherein a memory capacity of the first memory chip is larger than a memory capacity of the second memory chip, and an access speed of the first memory chip is lower than an access speed of the second memory chip.

5. The device of any preceding Claim, further comprising:
an external connecting terminal provided under the substrate; and
an IF (interface) chip disposed between the substrate and the chip stack, electrically connected to the first memory chip, the second memory chip, the first bridge chip and the external connecting terminal, and configured to function as an interface between the first memory chip, the second memory chip, and the first bridge chip and the external connecting terminal.

6. The device of Claim 5, wherein the chip stack includes:
a first electrode that electrically connects the first memory chip and the IF chip;
a second electrode that electrically connects the second memory chip and the IF chip;
a third electrode that electrically connects the first bridge chip and the IF chip;
a fourth electrode that electrically connects the first memory chip and the first bridge chip;
a fifth electrode that electrically connects the second memory chip and the first bridge chip; and
a sixth electrode that electrically connects the first memory chip, the second memory chip, and the first bridge chip and the external connecting terminal.

7. The device of Claim 6, wherein
one of the first to sixth electrodes includes a plurality of electrodes respectively provided in the plurality of chips, and a plurality of bumps provided alternately with the plurality of electrodes; and
one of the plurality of electrodes and one of the plurality of bumps are electrically connected via a pad.

8. The device of Claim 6, wherein
one of the first to sixth electrodes includes a plurality of electrodes respectively provided in the plurality of chips; and
one of the plurality of electrodes and another one of the plurality of electrodes are electrically connected via a pad.

9. The device of Claim 6, 7 or 8, further comprising a wiring provided under the chip stack, and electrically connected to the sixth electrode, the IF chip, and the external connecting terminal.

10. The device of Claim 9, further comprising a bump provided under the wiring, and electrically connecting the wiring and the external connecting terminal,
wherein the bump is electrically connected to the external connecting terminal via a wiring layer in the substrate.

11. The device of any one of Claims 6 to 10, wherein the IF chip includes:
a first pad electrically connected to the first electrode;
a second pad electrically connected to the second electrode;
a third pad electrically connected to the third electrode; and
a fourth pad electrically connected to the external connecting terminal.

12. The device of Claim 11, further comprising a wiring provided under the chip stack, and electrically connected to the sixth electrode, the fourth pad, and the external connecting terminal.

13. The device of any preceding Claim, wherein the plurality of chips further include:
a third memory chip, a type of the third memory chip being different from the type of the first memory chip and the type of the second memory chip; and
a second bridge chip that electrically connects the first memory chip and the third memory chip.

14. The device of Claim 13, wherein
the third memory chip is disposed above the substrate;
the first memory chip is disposed between the substrate and the third memory chip;
the second memory chip is disposed between the substrate and the first memory chip;
the first bridge chip is disposed between the first memory chip and the second memory chip, and configured to transfer data between the first memory chip and the second memory chip; and
the second bridge chip is disposed between the first memory chip and the third memory chip, and configured to transfer data between the first memory chip and the third memory chip.

15. The device of Claim 13 or 14, wherein the first memory chip, the second memory chip, and the third memory chip are different in at least one of a data retaining method, a memory capacity, and an access speed.

16. The device of Claim 5 or any Claim dependent thereon, wherein the chip stack includes:
a seventh electrode electrically connected to the first memory chip, the second memory chip, the first bridge chip, and the IF chip; and
an eighth electrode electrically connected to the first memory chip, the second memory chip, and the first bridge chip,
wherein the device further comprises a capacitor electrically connected to the seventh electrode and the eighth electrode.

17. The device of Claim 16, further comprising a wiring provided under the chip stack, and electrically connected to the seventh electrode, the IF chip, and the external connecting terminal.

18. The device of Claim 16 or 17, wherein the seventh electrode is a power supply wiring, and the eighth electrode is a ground wiring.

19. A semiconductor device comprising:
a first memory chip;
a second memory chip, a type of the second memory chip being different from a type of the first memory chip; and
a first bridge chip that electrically connects the first memory chip and the second memory chip, and is configured to transfer data between the first memory chip and the second memory chip.

20. The device of Claim 19, further comprising:
a third memory chip, a type of the third memory chip being different from the type of the first memory chip and the type of the second memory chip; and
a second bridge chip that electrically connects the first memory chip and the third memory chip, and is configured to transfer data between the first memory chip and the third memory chip.
